Europäisches Patentamt

**European Patent Office**

Office européen des brevets

(11) Veröffentlichungsnummer: **0 105 440**

**A2**

(12) **EUROPÄISCHE PATENTANMELDUNG**

(21) Anmeldenummer: **83109566.6**

(22) Anmeldetag: **26.09.83**

(51) Int. Cl.³: **H 01 J 37/05**
**H 01 J 37/252, H 01 J 37/10**

(30) Priorität: 30.09.82 DE 3236271

(43) Veröffentlichungstag der Anmeldung:
**18.04.84 Patentblatt 84/16**

(84) Benannte Vertragsstaaten:
**DE FR GB NL**

(71) Anmelder: **SIEMENS AKTIENGESELLSCHAFT**
**Berlin und München Wittelsbacherplatz 2**
**D-8000 München 2(DE)**

(72) Erfinder: **Lischke, Burkhard, Prof. Dr. Ing.**
**In der Heuluss 13**
**D-8000 München 82(DE)**

(72) Erfinder: **Plies, Erich, Dr. rer. nat.**
**Deisenhofenerstrasse 79 c**
**D-8000 München 90(DE)**

(54) **Spektrometerobjektiv für die Korpuskularstrahl-Meßtechnik.**

㊗ Eine Anordnung für die Korpuskularstrahl-Meßtechnik mit einem Objektiv (01, 02) zur Abbildung von Primärkorpuskeln (PE) auf eine Probe (PR) und mit einem Spektrometer zum Nachweis von Sekundärkorpuskeln (SE) soll eine wirksame Steigerung des Sondenstromes und/oder eine verbesserte Potentialauflösung ermöglichen. Ein Teil des Feldes des Objektivs (01, 02) ist zur Fokussierung der Sekundärkorpuskel (SE) auf die die Energieselektion bestimmende Elektrode (G2) vorgesehen.

FIG 1

Croydon Printing Company Ltd

SIEMENS AKTIENGESELLSCHAFT      Unser Zeichen
Berlin und München              VPA

82 P 1 9 3 3 E

Spektrometerobjektiv für die Korpuskularstrahl-Meßtechnik.

Die Erfindung betrifft eine Anordnung für die Korpuskularstral-Meßtechnik mit einem Objektiv zur Abbildung von Primärkorpuskeln auf eine Probe und mit einem Spektrometer zum Nachweis von Sekundärkorpuskeln nach dem Oberbegriff des Anspruchs 1.

Bei der Messung von elektrischen Potentialen mit einer Elektronensonde läßt sich eine Potentialauflösung erreichen, die gegeben ist durch

$$\Delta V = k \sqrt{p\, \Delta f\, /\, i_s}\,.$$

Diese Potentialauflösung wird umso besser, je größer der Strom $i_s$ der Elektronensonde ist, wenn die Spektrometerkonstante k, das Tastverhältnis p und die Bandbreite $\Delta f$ vorgegeben sind.

Wegen der üblichen Linsenfehler des die Elektronensonde formenden Objektivs hängt der Sondenstrom $i_s$ von diesen üblichen Linsenfehlern ab. Näherungsweise ist dieser Zusammenhang gegeben durch:

$$i_s = 1{,}13\, \pi\, R\, \alpha^2 \left\{ d^2 - \left[ (2\, C_F \Delta U \alpha / U)^2 + (C_Ö \alpha^3/2)^2 \right] \right\}\,.$$

Man erkennt, daß bei gegebenem Durchmesser d der Elektronensonde, bei gegebenem Richtstrahlwert R, bei gegebener Apertur $\alpha$ und bei gegebener Energiebreite $\Delta U$ der Elektro-

My 1 Bla 9.9.1982

nensonde der Strom $i_s$ der Elektronensonde umso kleiner wird, je größer der axiale Farbfehler $C_F$ und der Öffnungsfehler $C_{\ddot{O}}$ der Linse des die Elektronensonde formenden Objektivs werden.

Der Strom $i_s$ der Elektronensonde läßt sich wirksam steigern, wenn die Linsenfehler durch einen größeren Linsenstrom, mit dem die Linse erregt wird, verringert werden. Auf der anderen Seite verkürzt sich dadurch jedoch die Brennweite dieser Linse und damit der Arbeitsabstand, so daß dann kein Platz mehr für die Spektrometer-Detektoranordnung zwischen Probe und Objektivlinse bleibt.

Die Potentialmeßtechnik wurde bisher an die konventionelle Raster-Elektronenmikroskopie adaptiert. Das Spektrometer für die quantitative Potentialmessung wurde zwischen Probe und Objektivlinse angebracht (H.P. Feuerbaum, Scanning Electron Microscopy/1979/I, 285-296). Ein solches bekanntes Spektrometer erfordert einen Mindestarbeitsabstand, der nicht unterschritten werden kann. Eine Verringerung der Objektivlinsenfehler durch eine Verkürzung der Brennweite dieser Objektivlinse und damit des Arbeitsabstandes ist auf diese Weise nicht möglich.

Der Erfindung liegt die Aufgabe zugrunde, eine Anordnung der eingangs genannten Art anzugeben, mit der sich der Sondenstrom wirksam steigern läßt und/oder eine verbesserte Potentialauflösung zuläßt.

Diese Aufgabe wird erfindungsgemäß durch eine Anordnung nach dem Anspruch 1 gelöst. Ausgestaltungen und Vorteile der Erfindung sind in den Unteransprüchen der Beschreibung und der Zeichnung dargestellt.

Die Erfindung ermöglicht Objektivlinsenanordnungen mit integriertem Spektrometer (Spektrometerobjektiv), bei denen die Objektivlinsenfehler durch kürzere Brennweiten verringert sind. Bei gleichem Sondenstrom $i_s$ kann damit sowohl eine verbesserte Ortsauflösung als auch eine verbesserte Potentialauflösung erzielt werden.

Durch Überlagerung der elektrischen Felder des Spektrometer-Detektors mit den magnetischen Feldern der Objektivlinse wird eine elektronenoptische Einheit ('Filterlinse') geschaffen, mit der die Sekundärelektronen, die an der Probe ausgelöst worden sind, auf die Filterelektrode des Spektrometers abgebildet werden. Es lassen sich also beispielsweise die üblichen Spektrometergitter ohne Intensitätsverlust durch Blenden ersetzen. Man erreicht dadurch eine Unterdrückung der schädlichen Rückstreuelektronen, der Signaluntergrund wird kleiner und die Meßgenauigkeit wird verbessert.

Wegen der Farbfehler der magnetisch-elektrischen Filterlinse werden nur Sekundärelektronen einer bestimmten Energie auf die Filterblende fokussiert und passieren diese Filterblende; die anderen Sekundärelektronen werden durch diese Filterblende zurückgehalten.

Auf erfindungsgemäße Weise läßt sich die Spektrometer-Kennlinie verbessern und das Potentialauflösungsvermögen erhöhen bei entsprechender Wahl der Elektroden des Spektrometers, der Potentiale an diesen Elektroden und der Abstände dieser Elektroden zur Probe, zur Objektivlinse und zueinander.

Zusammengefaßt lauten die Vorteile einer erfindungsgemäßen Anordnung: Spektrometerobjektiv für erhöhten Sondenstrom, verbessertes Ortauflösungsvermögen und verbessertes Potentialauflösungsvermögen.

Ausführungsbeispiele der Erfindung werden im folgenden
anhand der Zeichnung näher beschrieben.

Fig.1 zeigt das Prinzip eines erfindungsgemäßen Spektrometerobjektivs.

Fig.2 zeigen erfindungsgemäße Ausführungen eines Spektro-
und 3 meterobjektivs mit einem üblichen Raster-Elektronenmikroskopobjektiv.

Fig.4 zeigen erfindungsgemäße Spektrometerobjektive mit
und 5 einem Streufeldobjektiv.

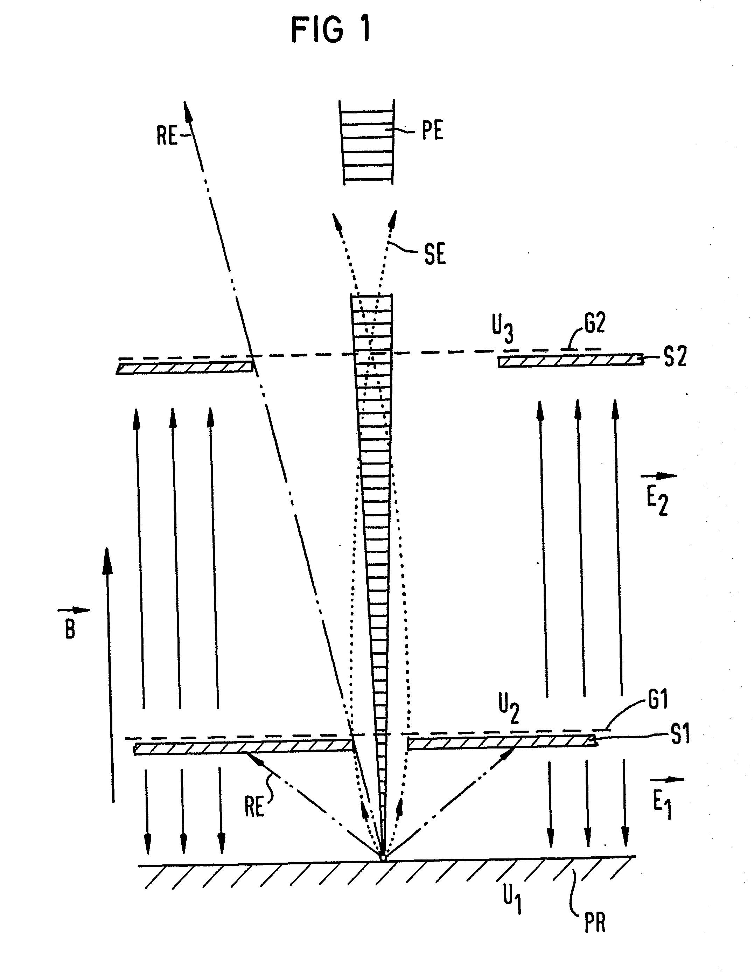

Fig.1 zeigt das Prinzip eines erfindungsgemäßen Spektrometerobjektivs. Die Primärelektronensonde PE löst auf
der Probe PR niederenergetische Sekundärelektronen SE
aus und verursacht hochenergetische Rückstreuelektronen
RE. Die Probe PR befindet sich auf dem Potential $U_1$.
Die an der Probe PR ausgelösten Sekundärelektronen SE
werden durch die Elektrode G1, die z.B. als eine Gitter-
elektrode ausgestaltet sein kann und die sich auf dem
Potential $U_2$ befindet, beschleunigt und durch das Potential $U_3$, auf dem sich die Elektrode G2 befindet, wieder
abgebremst. Auch die Elektrode G2 kann als Gitterelektrode ausgestaltet sein. Der durch die Elektrode G2 hindurchtretende Sekundärelektronenstrom ist ein Maß für
das zu messende Potential $U_1$, auf dem sich die Probe befindet.

Durch Überlagerung des Magnetlinsenfeldes B können die Sekundärelektronen SE von der Probe PR auf die Elektrode G2 fokussiert werden. Ohne Intensitätsverlust lassen sich infolge dieser Fokussierung die für die Elektroden G1, G2 üblichen Gitter durch feine Blenden ersetzen und damit die unerwünschten Rückstreuelektronen RE abfangen. Eine Blende als Elektrode G1 wirkt dabei als Aperturblende, eine Blende als Elektrode G2 bestimmt die Energieselektion.

Zwischen der Probe PR zwischen mit dem Potential $U_1$ und der Elektrode G1 mit dem Potential $U_2$ befindet sich das elektrische Feld $E_1$. Zwischen der Elektrode G1 mit dem Potential $U_2$ und der Elektrode G2 mit dem Potential $U_3$ befindet sich das retardierende elektrische Feld $E_2$. Das elektrische Feld $E_1$ dient zur Beschleunigung der Sekundärelektronen SE. Zwischen Probe PR und Elektrode G1 ist ein Schirm S1 zur Abschirmung von unerwünschten Rückstreuelektronen RE und zur Auswahl von achsennahen Sekundärelektronen SE angeordnet. Zwischen der Elektrode G1 und der Elektrode G2 ist ein weiterer Schirm S2 aus entsprechenden Gründen angeordnet.

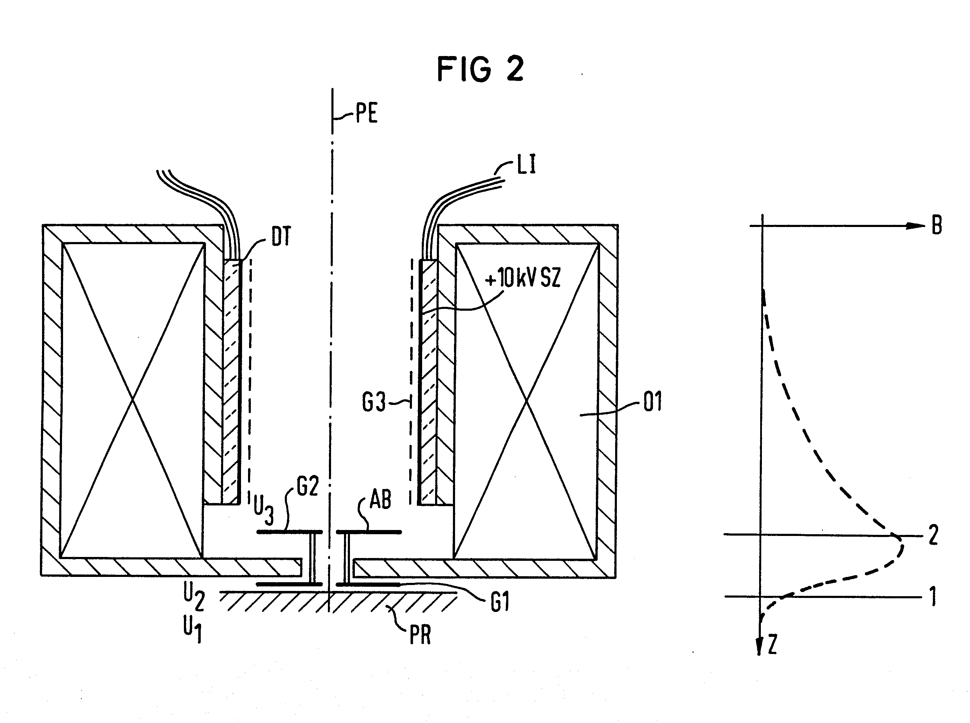

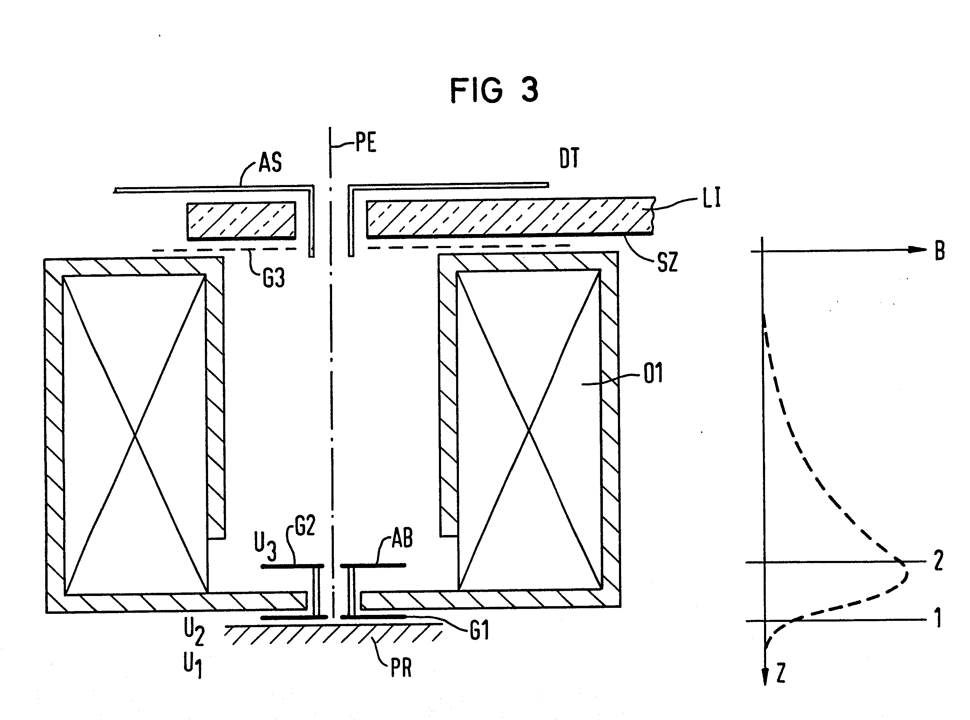

Die Fig.2 und 3 zeigen erfindungsgemäße Spektrometerobjektive mit üblichen Raster-Elektronenmikroskopobjektiven 01. Der Primärelektronenstrahl PE wird durch das variable Magnetfeld B der Linse des üblichen Raster-Elektronenmikroskopobjektivs 01 auf die Probe PR fokussiert. Zur Fokussierung der Sekundärelektronen SE auf die Elektrode G2 wird die an der Elektrode G2 anliegende Spannung $U_2$ passend eingestellt. Hinter der Spektrometeranordnung müssen die Sekundärelektronen SE durch Felder auf einen Detektor DT transferiert und dort nachgewiesen werden.

Geeignete Detektoren sind beispielsweise der Everhart-Thornley- und der Robinson-Detektor, Halbleiter-Schottky-Dioden, Channeltrons oder eine einfache Auffangelektrode zur Strom-Messung (vergl. das Lehrbuch von O.C. Wells, 'Scanning Electron Microscopy', McGraw-Hill 1974 oder das Lehrbuch von L. Reimer et al, 'Raster-Elektronenmikroskopie', 1. Aufl., Springer-Verlag, 1973).

Die Elektrode G1 auf dem Potential $U_2$ zur Beschleunigung der Sekundärelektronen SE ist in den Fig.2 mit 5 als Gitter-Elektrode oder als Gitter-Elektrode mit Schirm (Blende) auf einem Blendenschieber angebracht. Für die Elektrode G2 ist dabei eine Filterblende vorgesehen. Als Filterblende wirkt die übliche Aperturblende AB, die dazu auf das Potential $U_3$ gebracht wird. Die gefilterten Sekundärelektronen SE werden oberhalb der Linse des Raster-Elektronenmikroskopobjektivs 01 mit einem Detektor DT nachgewiesen. In den Fig.2 mit 5 ist jeweils rechts der axiale Verlauf des Magnetfeldes B aufgetragen. Der Anteil des Magnetfeldes B zwischen der Probe PR und der Aperturblende AB, in den Fig.2 mit 5 durch die Geraden 1, 2 begrenzt, dient zur Abbildung der Sekundärelektronen SE auf die Elektrode G2.

Die Anordnung für die Detektoren DT in den Fig.2 mit 5 sind jeweils symmetrisch dargestellt. Solche Anordnungen sind im Rahmen der Erfindung am besten geeignet. In den Umfang der Erfindung fallen jedoch auch Ausführungsbeispiele, die Abwandlungen zu den in den Fig.2 mit 5 dargestellten Detektoren DT aufweisen. Beispielsweise sind in Fig.2 Lichtleiter LI symmetrisch zur optischen Achse an der Innenwand des üblichen Raster-Elektronenmikroskopobjektivs 01 angeordnet. Die Oberfläche dieser Lichtleiter LI, die zur optischen Achse hinweist, ist mit einem Szintillator SZ versehen, der sich auf dem Potential +10kV befindet. Vor diesem Szintillator SZ in Richtung zur optischen Achse befindet sich ein Gitter G3 zur Nachbeschleunigung der Sekundärelektronen SE. Die Detektoranordnung nach Fig.2 kann so eingerichtet werden, daß die magnetische Feldstärke B und die elektrische Feldstärke zwischen der Elektrode G2 und dem Gitter G3 annähernd parallel verlaufen. Die Detektoranordnung nach Fig.3 weist symmetrisch zur optischen Achse Lichtleiter LI auf, welche außerhalb des Raster-Elektronenmikroskopobjektivs O1 parallel zur Oberfläche der Probe PR angeordnet sind. Diese Lichtleiter LI sind gegen die Primärelektronensonde PE mit einer Abschirmung AS versehen. Zum Innenraum des Rasterelektronenmikroskopobjektivs O1 hin weisen die Oberflächen dieser Lichtleiter LI Szintillatorschichten SZ auf, vor denen zum Innenraum des Raster-Elektronenmikroskopobjektivs O1 hin noch ein Gitter G3 angeordnet ist. Dabei passieren die Sekundärelektronen SE das Gitter G3, bevor sie auf den Szintillator SZ auftreffen.

Detektoranordnungen nach den Fig.2 oder 3 können auch so abgewandelt werden, daß sie nicht mehr symmetrisch zur optischen Achse sind oder daß die Bahnen der Sekundärelektronen auf dem Weg zwischen der Elektrode G2 und dem Detektor oder die Anordnung der Szintillatorschicht SZ abgewandelt sind. Wesentlich für die Erfindung ist, daß der Arbeitsabstand erfindungsgemäß derart verringert ist, daß zwischen dem Raster-Elektronenmikroskopobjektiv O1 und der Probe PR sich nur noch die Elektrode G1 befindet und daß die Elektrode G2 bereits innerhalb des Raster-Elektronenmikroskopobjektivs O1 angeordnet ist.

Bei Anordnungen nach den Fig.2 und 3 lassen sich die Sekundärelektronen beispielsweise auch seitlich durch ein elektrisches Feld absaugen und nachweisen.

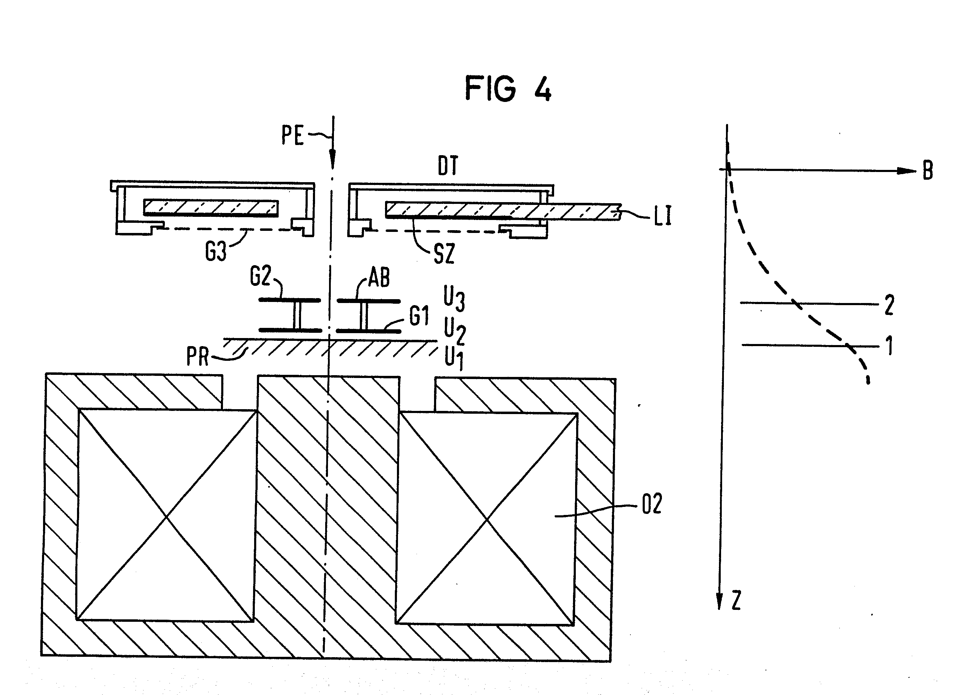

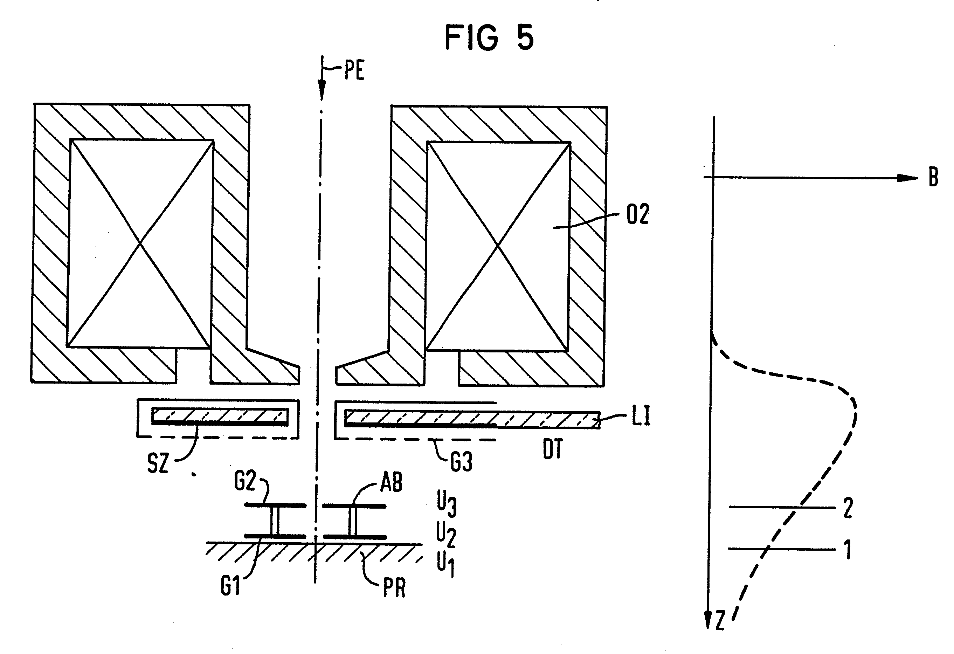

Die Fig.4 und 5 zeigen erfindungsgemäße Spektrometerobjektive mit Streufeld-Linsenobjektiven O2. Bei einem Streufeld-Linsenobjektiv O2 befindet sich das Magnetfeld B zur Formung des Elektronenstrahls außerhalb des Linsenobjektivkörpers. Wegen des starken Magnetfeldes B lassen sich bei Anordnungen nach den Fig.4 und 5 die Sekundärelektronen SE nicht mehr seitlich durch ein elektrisches Feld absaugen und dann im Detektor DT nachweisen. Dies muß in der Detektorgestaltung berücksichtigt werden. Anstelle der in den Fig.4 und 5 dargestellten Detektoranordnungen DT, die dem Detektor nach Fig.3 entsprechen, kann auch eine Detektoranordnung Verwendung finden, die dem Detektor DT nach Fig.2 in seiner Funktion entspricht. Die Bezeichnungen bei den Anordnungen nach Fig.4 und 5 und die Funktion dieser Anordnungen entsprechen im übrigen dem zu den Fig.1 mit 3 angegebenen. Für die Streufeld-Linsen sind prinzipiell auch andere Spektrometer-Detektor-Anordnungen geeignet, wenn sie nur in entsprechender Weise der Anwesenheit eines starken Magnetfeldes B Rechnung tragen. Eine räumliche Beschränkung für den Spektrometer-Detektor-Aufbau besteht bei Anordnungen nach den Fig.4 und 5 praktisch nicht.

0105440

82 P 1933 E

Patentansprüche:

1. Anordnung für die Korpuskularstrahl-Meßtechnik mit einem Objektiv (01, 02) zur Abbildung von Primärkorpuskeln (PE) auf eine Probe (PR) und mit einem Spektrometer zum Nachweis von Sekundärkorpuskeln (SE), dadurch g e k e n n z e i c h n e t , daß ein Teil des Feldes des Objektivs (01, 02) zur Fokussierung der Sekundärkorpuskel (SE) auf die die Energieselektion bestimmende Elektrode (G2) vorgesehen ist.

2. Anordnung nach Anspruch 1, dadurch g e k e n n z e i c h n e t , daß das Objektiv (01) ein übliches Raster-Elektronenmikroskop ist.

3. Anordnung nach Anspruch 1, dadurch g e k e n n z e i c h n e t , daß das Objektiv (02) ein Streufeld-Linsenobjektiv ist.

4. Anordnung nach einem der Ansprüche 1 bis 3, dadurch g e k e n n z e i c h n e t , daß das Spektrometer eine Elektrode (G1) zur Beschleunigung der Sekundärkorpuskel (SE) auf einem Potential ($U_2$) besitzt.

5. Anordnung nach einem der Ansprüche 1 bis 4, dadurch g e k e n n z e i c h n e t , daß die Elektroden(G1, G2) als feine Blenden ausgestaltet sind.

6. Anordnung nach einem der Ansprüche 1 bis 5, dadurch g e k e n n z e i c h n e t , daß die Spannung ($U_2$) an der eine Beschleunigung bewirkenden Elektrode (G1) zur Fokussierung der Sekundärkorpuskel (SE) auf die die Energieselektion bestimmende Elektrode (G2) vorgesehen ist.

0105440

82 P 1 9 3 3 E

7. Anordnung nach einem der Ansprüche 1 bis 6, dadurch g e k e n n z e i c h n e t , daß hinter der die Energieselektion bestimmenden Elektrode (G2) Felder vorgesehen sind zur Translation der Sekundärkorpuskel (SE) auf einen Detektor (DT).

8. Anordnung nach Anspruch 7, dadurch g e k e n n - z e i c h n e t , daß der Detektor (DT) zusammen mit einer nachbeschleunigenden Elektrode (G3) so angeordnet ist, daß die magnetische und die elektrische Feldstärke zwischen der die Energieselektion bestimmenden Elektrode (G2) und der nachbeschleunigenden Elektrode (G3) annähernd parallel verlaufen.

9. Anordnung nach Anspruch 7 oder 8, dadurch g e - k e n n z e i c h n e t , daß der Detektor (DT) im wesentlichen symmetrisch zur optischen Achse geformt ist.

10. Anordnung nach einem der Ansprüche 1 bis 9, dadurch g e k e n n z e i c h n e t , daß mindestens eine Elektrode (G1, G2, G3) aus einer Kombination von Gitter und Schirm (Blende) (S1, S2) besteht.

1/5

FIG 1

FIG 2

2/5

0105440

# FIG 3

FIG 4

# FIG 5

0105440